# EUROPÄISCHE PATENTSCHRIFT

(11) **EP 3 028 053 B1**
(45) Veröffentlichungstag und Bekanntmachung des Hinweises auf die Patenterteilung: **25.09.2019**
(21) Anmeldenummer: 14741906.3
(22) Anmeldetag: 23.07.2014
(51) Int. Cl.: G01R 15/18, G01R 19/00, G01R 31/40

(54) **VORRICHTUNG ZUM ERFASSEN VON WECHSELSTROMANTEILEN IN EINEM GLEICHSTROMKREIS UND VERWENDUNG DER VORRICHTUNG**
APPARATUS FOR DETECTING AC COMPONENTS IN A DC CIRCUIT AND USE OF THE APPARATUS
DISPOSITIF DE DÉTECTION DE PROPORTIONS DE COURANT ALTERNATIF DANS UN CIRCUIT À COURANT CONTINU ET UTILISATION DUDIT DISPOSITIF

(30) Priorität: 30.07.2013 DE 102013108166
(43) Veröffentlichungstag der Anmeldung: 08.06.2016
(73) Patentinhaber: SMA Solar Technology AG, 34266 Niestetal (DE)
(72) Erfinder: BEHRENDS, Holger, 26817 Rhauderfehn (DE); KRATOCHVIL, Marcel, 34121 Kassel (DE); ORBITA, Gary, 34131 Kassel (DE)
(74) Vertreter: Lahnor, Peter
(86) Internationale Anmeldenummer: PCT/EP2014/065787
(87) Internationale Veröffentlichungsnummer: WO 2015/014683

(56) Entgegenhaltungen:
- WO-A1-96/30988
- DE-A1- 2 430 294
- DE-A1- 3 139 598
- US-A1- 2011 141 644
- RAY W F: "WIDE BANDWIDTH ROGOWSKI CURRENT TRANSDUCERS: PART II: THE INTEGRATOR", EPE. THE EUROPEAN POWER ELECTRONICS AND DRIVES JOURNAL, VDE VERLAG, BERLIN, DE, Bd. 3, Nr. 2, 1. Juni 1993 (1993-06-01), Seiten 116-122, XP001121295,

## Beschreibung

### Technisches Gebiet der Erfindung

Die Erfindung bezieht sich auf eine Vorrichtung zur Erfassung von Wechselstromanteilen (AC-Anteilen) eines in einem Gleichstromkreis (DC-Stromkreis) fließenden elektrischen Stromes, insbesondere zur Erfassung von Lichtbogen- und/oder Kommunikationssignalen in elektrischen Stromkreisen, die für den Transport von Gleichstrom (DC) mit hohen DC-Stromstärken vorgesehen sind. Weiterhin bezieht sich die Erfindung auf eine Verwendung der Vorrichtung innerhalb einer Photovoltaikanlage.

### Stand der Technik

Herkömmliche Stromsensoren zur Erfassung von AC-Anteilen in einem Gleichstromkreis arbeiten nach dem Prinzip, eine über ein von dem AC-Anteil erzeugtes zeitlich veränderliches Feld in einem induktiven Bauteil induzierte Wechselspannung zu erfassen, wobei die induzierte Wechselspannung dem zu messenden AC-Anteil entspricht, insbesondere proportional dazu ist. Als induktive Bauteile werden insbesondere sogenannte Stromwandler eingesetzt, die aus Spulen mit einem magnetischen Kernmaterial bestehen und hohe Induktivitätswerte bei gleichzeitig kleiner Bauform und geringen Windungszahlen erreichen.

Insbesondere in DC-Stromkreisen von Photovoltaik-Anlagen treten regelmäßig DC-Stromstärken in der Größenordnung einiger Ampere bis zu einigen Dutzend Ampere auf. Gleichzeitig betragen die Amplituden von AC-Anteilen, die beispielsweise von zu detektierenden Lichtbögen im DC-Stromkreis im Frequenzbereich von einigen kHz bis zu einigen hundert kHz hervorgerufen werden, nur wenige Milliampere.

Bei der Verwendung von Stromsensoren mit magnetischem Kernmaterial muss eine Sättigung des Kernmaterials insbesondere bei solchen hohen DC-Stromstärken vermieden werden. Dazu wird entweder ein Kernmaterial mit einer geringen Permeabilität eingesetzt oder das Volumen des Kerns erhöht. Eine geringere Permeabilität wirkt sich jedoch negativ auf die Empfindlichkeit und Linearität des Sensors aus, was sich insbesondere bei der Messung sehr kleiner AC-Ströme über einen weiten Frequenzbereich bemerkbar macht. Ein größeres Kernvolumen wiederum wirkt sich negativ auf die Baugröße und damit auf die Kosten aus.

Alternativ sind Stromsensoren bekannt, die als Luftspule ohne magnetischen Kern aufgebaut sind und die toroidförmig um einen Leiter, in dem der AC-Anteil gemessen werden soll, angeordnet sind. Aufgrund des fehlenden Kernmaterials sind diese frei von Sättigungserscheinungen und somit gut für die Messung von AC-Anteilen auf hohen DC-Strömen geeignet. Solche sogenannten Rogowski-Sensoren eignen sich insbesondere für die Messung von AC-Anteilen mit großen Amplituden oder für die Messung von kleinen AC-Anteilen bei hohen Frequenzen. Sie sind jedoch nur bedingt für die Messung kleiner AC-Anteile bei niedrigen Frequenzen geeignet.

Die Empfindlichkeit induktiver Stromsensoren ist frequenzabhängig, so dass eine umso höhere Induktivität gegeben sein muss, je kleiner die Frequenz des zu messenden AC-Anteils ist. Die Induktivität lässt sich durch Erhöhung der Permeabilität des Kernmaterials oder durch eine größere Anzahl an Windungen erhöhen, wodurch die Baugröße und die Kosten steigen.

Die DE2430294A1 offenbart eine Einrichtung zur Überwachung des ungestörten Stromflußes in elektrischen Antriebsanlagen, die eine Auskoppelschaltung für Hochfrequenz-Spannungen umfasst, wobei die Auskoppelschaltung einen Übertrager umfasst und mit einer Messeinrichtung in Verbindung steht. Der über die Auskoppelschaltung zu übertragende Frequenzbereich wird dabei durch die Wahl von Kapazitäten von Kondensatoren im Zusammenhang mit der durch den Übertrager gebildeten Induktivität festgelegt.

### Aufgabe der Erfindung

Der Erfindung liegt die Aufgabe zugrunde, eine Vorrichtung aufzuzeigen, die es ermöglicht, Wechselstromanteile (AC-Anteile) eines in einem Gleichstromkreis (DC-Stromkreis) fließenden elektrischen Stromes in einem vorgegebenen Frequenzbereich mit hoher Empfindlichkeit und Genauigkeit zu erfassen, wobei die Vorrichtung kostengünstig herstellbar ist.

### Lösung der Aufgabe

Die Aufgabe wird gelöst durch eine Vorrichtung zur Erfassung von Wechselstromanteilen (AC-Anteilen) eines in einem Gleichstromkreis (DC-Stromkreis) fließenden elektrischen Stromes, die eine in dem DC-Stromkreis angeordnete Induktivität aufweist, wobei elektrisch parallel zu der Induktivität ein AC-Pfad angeordnet ist, der eine Reihenschaltung aus einer Kapazität und einer primärseitigen Wicklung eines Übertragers umfasst. Weiterhin umfasst die Vorrichtung eine Spannungsmesseinrichtung. Die Vorrichtung zeichnet sich durch eine Tiefpassschaltung aus, wobei eine sekundärseitige Wicklung des Übertragers über die Tiefpassschaltung mit der Spannungsmesseinrichtung verbunden ist, d.h. die sekundärseitige Wicklung des Übertragers ist mit einem Eingang und die Spannungsmesseinrichtung mit einem Ausgang der Tiefpass-Schaltung verbunden.

Die Vorrichtung besteht somit elektrisch aus zwei Pfaden, einem AC-Pfad und einem DC-Pfad, die den im DC-Stromkreis fließenden elektrischen Strom in einen AC-Anteil und einen DC-Anteil aufteilen, sowie einer nachgeschalteten Linearisierung des AC-Anteils mittels der Tiefpassschaltung. Der DC-Pfad umfasst eine Induktivität, die für den DC-Anteil durchlässig ist, für den AC-Anteil jedoch einen frequenzabhängigen Widerstand darstellt und diesen entsprechend hemmt, indem die Impedanz des DC-Pfades mit zunehmender Frequenz linear ansteigt. Der AC-Pfad hingegen ist aufgrund der darin angeordneten Kapazität für den DC-Anteil blockiert. Im Ergebnis werden AC-Anteile des Stromes bevorzugt über den AC-Pfad geleitet.

Der Vorteil dieser Schaltung ist, dass die im AC-Pfad angeordneten Bauteile nicht für den hohen im DC-Pfad fließenden DC-Strom ausgelegt werden müssen und somit insbesondere bei der Auslegung des Übertragers keine Sättigungseffekte zu berücksichtigen sind und Komponenten im AC-Pfad nur eine geringe Stromtragfähigkeit aufweisen müssen. Bei einer DC-Stromstärke von beispielsweise einigen zehn Ampere im DC-Pfad kann im erfindungsgemäßen AC-Pfad ein Übertrager verwendet werden, der um Größenordnungen kleiner ist als wenn er auf herkömmliche Weise im DC-Pfad angeordnet wäre. Lediglich die im DC-Pfad befindliche Spule muss so beschaffen sein, dass sie bei den auftretenden DC-Stromstärken nicht sättigt.

In einer Ausführungsform weist ein aus der Induktivität im DC-Pfad und der Kapazität im AC-Pfad gebildeter Hochpass eine Grenzfrequenz auf, die oberhalb von Frequenzen von zu detektierenden AC-Anteilen liegt. Diese Auslegung ist auf den ersten Blick für die Erfassung der zu detektierenden AC-Anteile ungünstig, da die Übertragungscharakteristik des Hochpass unterhalb der Grenzfrequenz einen mit ansteigender Frequenz ansteigenden, d.h. einen nichtlinearen Verlauf aufweist. Es ergibt sich jedoch zum einen der Vorteil, dass umso kleinere Induktivitäten und Kapazitäten verwendet werden können, je höher die Grenzfrequenz gewählt wird.

Zum anderen bewirkt die mit der sekundärseitigen Wicklung des Übertragers verbundene Tiefpassschaltung eine Linearisierung der Übertragungscharakteristik. Dazu wird die Tiefpassschaltung derart ausgelegt, dass eine Übertragungsfunktion der Tiefpassschaltung in einem vorgegebenen Frequenzbereich, innerhalb dem die zu detektierenden AC-Anteile liegen, einen Verlauf aufweist, der komplementär zum Verlauf der Übertragungsfunktion des Hochpass in dem vorgegebenen Frequenzbereich ist. Konkret bedeutet dies, dass die Übertragungsfunktion der Tiefpassschaltung in einem vorgegebenen Frequenzbereich eine vergleichbare Steigung wie die Übertragungsfunktion des Hochpass in dem vorgegebenen Frequenzbereich aufweist, jedoch ein entgegengesetztes Vorzeichen hat. Insgesamt besitzt die Vorrichtung damit in dem vorgegebenen Frequenzbereich eine annähernd konstante Gesamt-Übertragungsfunktion, zumindest aber eine Gesamt-Übertragungsfunktion mit einer gegenüber der Übertragungsfunktion des Hochpass reduzierter Variation, d.h. die Steigung und/oder die Schwankungsbreite der Übertragungsfaktors ist reduziert. Konkret kann in einem realisierten Anwendungsfall der Verlauf der Gesamt-Übertragungsfunktion in dem vorgegebenen Frequenzbereich eine mindestens um den Faktor 5 gegenüber der Übertragungsfunktion des Hochpass reduzierte Variation aufweisen.

Dabei umfasst der vorgegebene Frequenzbereich die zu detektierenden AC-Anteile und liegt unterhalb der Grenzfrequenz des Hochpass aus der Induktivität im DC-Pfad und der Kapazität im AC-Pfad. Liegt nun zwischen der Grenzfrequenz (beispielsweise einige hundert Kilohertz) und einer unteren Grenze des vorgegebenen Frequenzbereichs der zu detektierenden AC-Anteile (beispielsweise wenige zehn Kilohertz) ein Faktor größer zwei, dann überwiegen die durch die Verkleinerung der Induktivitäten erzielten Vorteile die Nachteile, die durch den erhöhten Bauteileaufwand für die nachträgliche Linearisierung durch die Tiefpassschaltung entstehen. Bevorzugt liegt die Grenzfrequenz des Hochpass mindestens um einen Faktor 5, besonders bevorzugt um einen Faktor 10 oberhalb einer unteren Grenze des vorgegebenen Frequenzbereiches, mithin oberhalb des vorgegebenen Frequenzbereichs der zu detektierenden AC-Anteile.

In einer Ausführungsform der Erfindung umfasst der Übertrager einen Terminierungswiderstand, der bevorzugt elektrisch parallel zur sekundärseitigen Wicklung des Übertragers angeordnet ist. Bevorzugt kann der Terminierungswiderstand derart ausgelegt werden, dass eine Resonanzüberhöhung der Übertragungsfunktion des Hochpass an seiner Grenzfrequenz derart gedämpft beziehungsweise abgeflacht wird, dass sich eine Übertragungsfunktion mit einem monoton steigenden Verlauf insbesondere im Bereich der Grenzfrequenz des Hochpass ergibt. Alternativ kann der Terminierungswiderstand im Vergleich zur vorgenannten Ausführungsform vergrößert werden, so dass die primärseitige Wicklung des Übertragers mit der in Reihe dazu geschalteten Kapazität einen Bandpass mit ausgeprägtem Resonanzmaximum unterhalb der Grenzfrequenz des Hochpass ausbilden

In einer weiteren Ausführungsform der Erfindung umfasst der DC-Pfad eine Bandsperre bestehend aus einer Parallelschaltung aus der Induktivität und einer Kapazität, wodurch die Impedanz des DC-Pfades nicht mehr nur linear mit steigender Frequenz ansteigt, sondern im Frequenzbereich einer durch die Auslegung der Induktivität und der Kapazität bestimmten Resonanzfrequenz der Bandsperre sehr hochohmig wird. Die zu detektierenden AC-Anteile werden dann insbesondere in diesem Frequenzbereich weitgehend ausschließlich über den AC-Pfad geführt. In einer bevorzugten Ausführungsform werden der Terminierungswiderstand des Übertragers und die Kapazität im AC-Pfad derart ausgelegt, dass die primärseitige Wicklung des Übertragers mit der in Reihe dazu geschalteten Kapazität einen Bandpass darstellen, dessen Resonanzfrequenz in demselben Frequenzbereich liegt wie die Resonanzfrequenz der Bandsperre. D.h., bevorzugt fällt die minimale Impedanz des AC-Pfades zusammen mit der maximalen Impedanz des DC-Pfades, so dass ein optimales Bandpassverhalten erzielt wird. Durch die mit der sekundärseitigen Wicklung des Übertragers verbundene Tiefpassschaltung werden dann Frequenzbereiche insbesondere unterhalb der Resonanzfrequenz von Bandpass und/oder Bandsperre linearisiert. Darüber hinaus kann die Resonanzüberhöhung der Übertragungsfunktion an der Resonanzfrequenz von Bandpass und/oder Bandsperre zur optimalen Erfassung weiterer, insbesondere schmalbandiger AC-Anteile wie beispielsweise Powerline-Kommunikationssignale genutzt werden

Die Tiefpassschaltung kann als herkömmlicher passiver Tiefpass oder alternativ als aktiver Tiefpass insbesondere als ein- oder mehrstufiger, invertierender oder nicht-invertierender Integrator ausgebildet sein. Durch eine Verstärkung, bei Verwendung eines aktiven Tiefpasses beispielsweise mittels Operationsverstärkern, im Frequenzbereich der zu detektierenden AC-Anteile kann erreicht werden, dass die durch die Kombination aus Induktivität beziehungsweise Bandsperre und Bandpass verursachte Dämpfung der zu detektierenden AC-Anteile ausgeglichen wird.

In einer Ausführungsform der Erfindung besteht die Tiefpassschaltung aus einer Integratorschaltung erster Ordnung, die einen Operationsverstärker umfasst. In einer alternativen Ausführungsform besteht die Tiefpassschaltung aus einer Integratorschaltung 2. Ordnung, die eine Reihenschaltung von Operationsverstärkern umfasst.

In einer weiteren Ausführungsform der Erfindung ist parallel zur sekundärseitigen Wicklung des Übertragers eine Kapazität angeordnet, die zusammen mit einer Streuinduktivität der sekundärseitigen Wicklung des Übertragers einen Resonanzkreis ausbildet, dessen Resonanzfrequenz im Bereich der unteren Grenze des Frequenzbereichs der zu detektierenden AC-Anteile, zumindest jedoch unterhalb der Eckfrequenz des Hochpass beziehungsweise unterhalb der Resonanzfrequenz von Bandsperre und/oder Bandpass liegt.

Die von der Spannungsmesseinrichtung erfassten Wechselstromanteile können von einer Auswerteeinrichtung, beispielsweise einem Signalprozessor, hinsichtlich vorgebbarer Charakteristika ausgewertet werden. Insbesondere Lichtbögen, die in dem Gleichstromkreis bevorzugt bei hohen Amplituden des im Gleichstromkreis fließenden Gleichstromes im Bereich einiger Ampere, wie sie insbesondere in Gleichstromkreisen von Photovoltaik auftreten können, besitzen erzeugen charakteristische AC-Anteile, die von der Spannungsmesseinrichtung bei erfindungsgemäßer Auslegung der Vorrichtung erfasst und von der Auswerteeinrichtung als Lichtbogensignale identifiziert werden können.

Darüber hinaus kann dem im Gleichstromkreis fließenden elektrischen Strom zu Kommunikationszwecken ein Wechselstromanteil aufgeprägt sein. Solche sogenannten Powerline-Kommunikationssignale werden von der Spannungsmesseinrichtung ebenfalls erfasst und können von der Auswerteeinrichtung entsprechend ausgewertet und, insbesondere auf digitalem Wege, an einen Powerline-Kommunikationspartner weitergeleitet werden.

In einer Ausführungsform der Erfindung ist die Auswerteeinrichtung dazu eingerichtet, die mittels der Spannungsmesseinrichtung erfassten AC-Anteile in einem ersten vorgegebenen Frequenzbereich zur Detektion von Lichtbögen im DC-Stromkreis und in einem zweiten, vom ersten Frequenzbereich unterschiedlichen Frequenzbereich zum Empfang von Powerline-Kommunikationssignalen auszuwerten. Dabei liegt die untere Grenze des ersten vorgegebenen Frequenzbereichs bevorzugt mindestens um einen Faktor 5, besonders bevorzugt mindestens um einen Faktor 10 unterhalb der Resonanzfrequenz der Bandsperre und/oder des Bandpass, mithin in dem durch die Vorrichtung linear übertragenen Frequenzbereich. Eine mittlere Frequenz der Powerline-Kommunikationssignale hingegen liegt bevorzugt oberhalb der Resonanzfrequenz der Bandsperre und/oder des Bandpass; besonders bevorzugt entspricht die mittlere Frequenz der Powerline-Kommunikationssignale der Resonanzfrequenz der Bandsperre und/oder des Bandpass. Dies ist besonders zweckmäßig für schmalbandige Powerline-Kommunikationssignale, die zur Erzielung hinreichender Kommunikationsbandbreiten regelmäßig in einem höheren Frequenzbereich jenseits von 100 kHz angesiedelt sind.

Die Vorrichtung ist besonders geeignet zur Verwendung in einem Gleichstromkreis einer Photovoltaikanlage, da in einem solchen Gleichstromkreis zum einen sehr hohe Gleichströme mit Amplituden von einigen Ampere bis zu einigen zehn Ampere fließen können, die den Einsatz herkömmlicher Stromsensoren erschweren. Zum anderen kann es beispielsweise bei schadhaften Steckverbindungen oder unzureichenden Leitungsisolationen im Gleichstromkreis einer Photovoltaikanlage gerade wegen der hohen Gleichströme zu Lichtbögen kommen, die es im Sinne einer Gefahrenabwehr zu detektieren gilt. Darüber hinaus werden die Gleichstromkreise einer Photovoltaikanlage genutzt, um mittels Powerline-Kommunikation einen Datenaustausch zwischen verschiedenen Komponenten der Photovoltaikanlage, beispielsweise zwischen Wechselrichtern und teils entfernt an Photovoltaikmodulen angeordneten Elektroniken wie Trennschaltern oder Sensoren zu ermöglichen.

### Figuren

Im Folgenden wird die Erfindung anhand in den Figuren dargestellter bevorzugter Ausführungsbeispiele weiter erläutert und beschrieben.
**Fig. 1** zeigt eine Ausführungsform einer erfindungsgemäßen Vorrichtung.
**Fig. 2** zeigt eine weitere Ausführungsform einer erfindungsgemäßen Vorrichtung.
**Fig. 3** zeigt Übertragungsfunktionen der erfindungsgemäßen Vorrichtung in einer schematischen Darstellung.
**Fig. 4** zeigt eine Ausführungsform einer Tiefpassschaltung als Bestandteil einer erfindungsgemäßen Vorrichtung.
**Fig. 5** zeigt eine weitere Ausführungsform einer erfindungsgemäßen Vorrichtung.

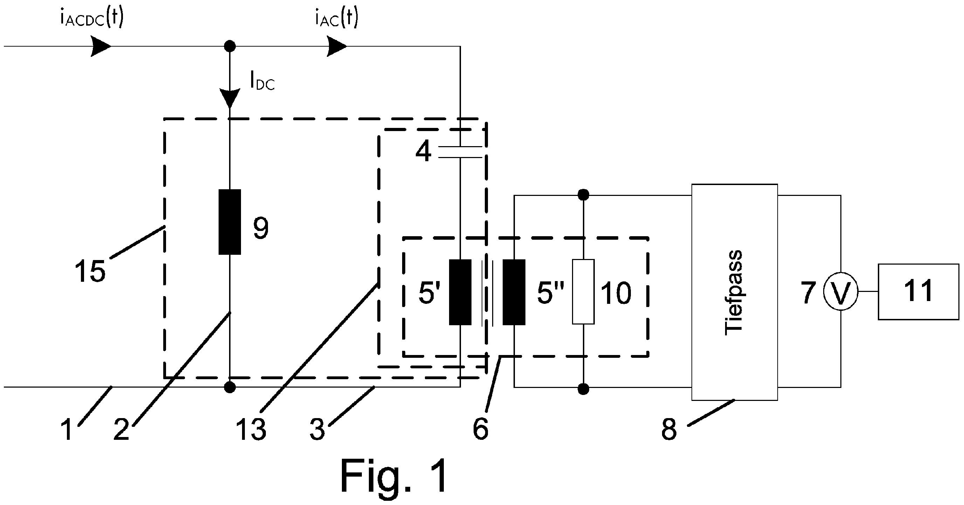

Fig. 1 zeigt eine Ausführungsform einer erfindungsgemäßen Vorrichtung. In einem Gleichstromkreis 1 fließt ein elektrischer Strom i_{ACDC}(t). Der Gleichstromkreis 1 umfasst einen DC-Pfad 2, in dem eine Induktivität 9 angeordnet ist. Elektrisch parallel zum DC-Pfad 2 ist ein AC-Pfad 3 angeordnet, in dem eine Reihenschaltung aus einer Kapazität 4 und einer primärseitigen Wicklung 5' eines Übertragers 6 angeordnet ist. Elektrisch parallel zu einer sekundärseitigen Wicklung 5" des Übertrages 6 ist ein Terminierungswiderstand 10 angeordnet. Der Terminierungswiderstand 10 lässt sich durch Teilung mit dem Quadrat des Übersetzungsverhältnisses des Übertragers 6 auf die Primärseite transferieren. Dadurch stellt die Reihenschaltung aus der Kapazität 4 und der primärseitigen Wicklung 5' einen Bandpass 13 dar.

Aufgrund der frequenzabhängigen Impedanzen der Kapazität 4 und der Induktivität 9 teilt sich der elektrische Strom i_{ACDC}(t) auf in einen Gleichstromanteil I_{DC} (DC-Anteil), der über den durch die Induktivität 9 gebildeten DC-Pfad 2 fließt, sowie in Wechselstromanteile i_{AC}(t) (AC-Anteile), die über den AC-Pfad 3 fließen. Somit stellt diese Anordnung aus Kapazität 4 und Induktivität 9, gegebenenfalls unter Berücksichtigung der primärseitigen Wicklung 5' des Übertragers 6, einen Hochpass 15 dar, wobei nicht ausgeschlossen wird, dass Wechselstromanteile des Stromes i_{ACDC}(t) auch über die Induktivität 9 fließen.

Eine Übertragungsfunktion dieses Hochpass 15 weist dabei einen linear ansteigenden Verlauf in einem Frequenzbereich unterhalb einer Grenzfrequenz auf, wobei die Grenzfrequenz aus der Dimensionierung der Kapazität 4, der Induktivität 9 und des Übertragers 6 bestimmt ist. Je nach Dimensionierung des Terminierungswiderstandes 10 kann eine bei einem etwaigen Verzicht auf den Terminierungswiderstand 10 im Bereich der Grenzfrequenz auftretende Resonanzüberhöhung gedämpft werden, so dass die Übertragungsfunktion des Hochpass 15 zumindest bis zur Grenzfrequenz monoton ansteigt. Oberhalb der Grenzfrequenz ist die Übertragungsfunktion des Hochpass 15 konstant. Darüber hinaus kann durch eine geeignete Erhöhung des Widerstandswertes des Terminierungswiderstandes 10 ein zusätzliches Resonanzmaximum unterhalb der Grenzfrequenz erzeugt werden, so dass bei der Resonanzfrequenz dieses Resonanzmaximums schmalbandige AC-Anteile, beispielsweise Kommunikationssignale, besonders effizient übertragen werden.

Die AC-Anteile i_{AC}(t), die entlang des AC-Pfades fließen, werden durch den Übertrager 6 auf dessen sekundärseitige Wicklung 5" transformiert. Hier könnte grundsätzlich bereits eine Messung der in der sekundärseitige Wicklung 5" induzierten Spannung, zum Beispiel über dem Terminierungswiderstand 10 mittels einer Spannungsmesseinrichtung 7, beispielsweise mittels eines Voltmeters oder eines Analog-Digital-Wandlers stattfinden, um die AC-Anteile i_{AC}(t) zu ermitteln; allerdings hängt das Verhältnis aus der jeweiligen Amplitude eines AC-Anteils i_{AC}(t) im elektrischen Strom i_{ACDC}(t) mit einer gegebenen Frequenz zu der Amplitude der in der sekundärseitigen Wicklung 5" induzierten Spannung erheblich von der gegebenen Frequenz ab. Diese als Nichtlinearität einer Übertragungsfunktion bekannte Eigenschaft ist bei der hier dargestellten Anordnung für die in der sekundärseitigen Wicklung 5" induzierte Spannung besonders ausgeprägt, wenn die Frequenz eines Wechselstromanteils i_{AC}(t) unterhalb der Grenzfrequenz des Hochpass 15 aus liegt.

Zwischen der sekundärseitigen Wicklung 5" und der Spannungsmesseinrichtung 7 ist daher eine Tiefpassschaltung 8 angeordnet. Diese Tiefpassschaltung 8 ist derart ausgelegt, dass ihre Übertragungsfunktion in einem Frequenzbereich, der unterhalb der Grenzfrequenz des Hochpass 15 liegt und der AC-Anteile i_{AC}(t) enthält, deren Detektion von Interesse ist (beispielsweise Lichtbogen-Signale oder auch Powerline-Kommunikationssignale), gerade komplementär zur Übertragungsfunktion des Hochpass 15 ist. Komplementär bedeutet hier, dass die Übertragungsfunktion der Tiefpassschaltung 8 in dem Frequenzbereich denselben Betrag der Steigung wie die Übertragungsfunktion des Hochpass besitzt, wobei die jeweiligen Steigungen jedoch entgegengesetzte Vorzeichen aufweisen. Im Ergebnis ist die Gesamt-Übertragungsfunktion der Vorrichtung gemäß Fig. 1 als Kombination der beiden genannten Übertragungsfunktionen in einem weiten Frequenzbereich unterhalb der Grenzfrequenz des Hochpass 15 konstant oder nahezu konstant.

Konkret bedeutet dies, dass die Gesamt-Übertragungsfunktion eine Variation, d.h. eine verbleibende Steigung beziehungsweise eine Schwankungsbreite aufweist, die gegenüber der Variation der Übertragungsfunktion des Hochpass 15, die im Wesentlichen deren Steigung entspricht und beispielsweise 40 dB/Dekade beträgt, erheblich reduziert ist, insbesondere keine monotone Steigung aufweist und beispielsweise nur noch einer Schwankung im Bereich von wenigen dB/Dekade entspricht. Damit wird in diesem Frequenzbereich, der zu detektierende AC-Anteile umfasst, eine lineare Abbildung der eingangsseitig der Vorrichtung im Gleichstromkreis 1 fließenden Wechselstromanteile auf die ausgangsseitig mittels der Spannungsmesseinrichtung 7 gemessenen Wechselspannungen erzielt. Die von der Spannungsmesseinrichtung 7 gemessenen Wechselspannungen werden einer Auswerteeinrichtung 11 zugeführt, die die gemessenen Wechselspannungen auswertet.

Durch den Einsatz der Tiefpassschaltung 8 können die Induktivität 9 und Kapazität 4 somit für einen sehr viel höheren Frequenzbereich als denjenigen der zu detektierenden AC-Anteile ausgelegt werden, so dass insbesondere für die Induktivität 9 deutlich kleinere Bauteile verwendet werden können. Soll beispielsweise ein AC-Anteil i_{AC}(t) in einem Frequenzbereich von 10 kHz bis 100 kHz von der Spannungsmesseinrichtung 7 mit einer konstanten Übertragungsfunktion gemessen werden, ist bei Verzicht auf die durch die Tiefpassschaltung 8 erzielbare Kompensation des nichtlinearen Verlaufs der Übertragungsfunktion unterhalb der Grenzfrequenz des Hochpass 15 und bei gegebener Kapazität 4 von 10 µF eine Induktivität 9 von etwa 25 µH notwendig, um eine Grenzfrequenz von etwa 10 kHz einzustellen; mit Einsatz der Tiefpassschaltung 8 kann die Grenzfrequenz jedoch deutlich erhöht werden beispielsweise um einen Faktor 10 auf etwa 100 kHz, so dass für die Induktivität 9 bei gleichbleibender Kapazität C_AC nur noch etwa 250 nH notwendig sind. Insgesamt sinken dadurch Kosten, Verluste und Baugrößen der benötigten Bauteile.

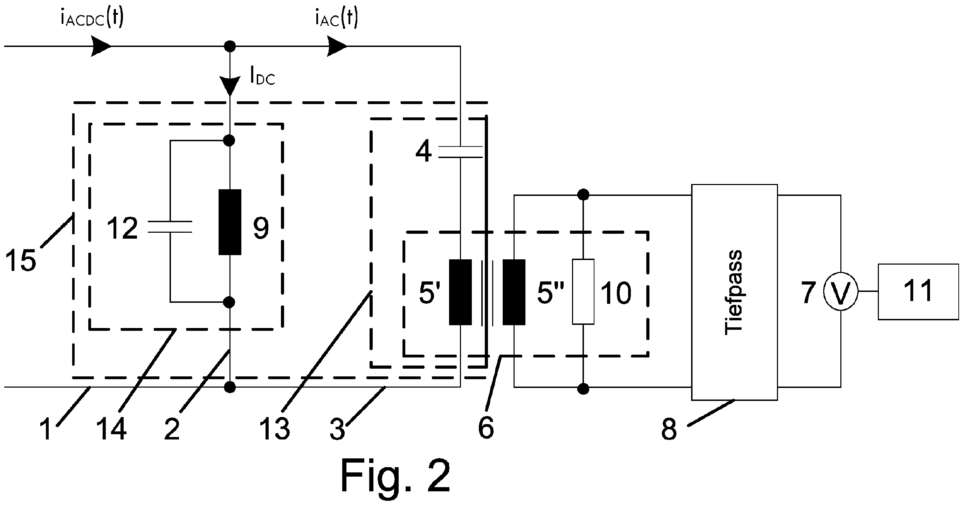

Fig. 2 zeigt eine weitere Ausführungsform, bei welcher im DC-Pfad 2 elektrisch parallel zur Induktivität 9 eine Kapazität 12 angeordnet ist. Die Parallelschaltung aus Induktivität 9 und Kapazität 12 stellt eine im DC-Pfad 2 angeordnete Bandsperre 14 dar, die sich durch eine frequenzabhängige Impedanz mit einer maximalen Impedanz bei einer Resonanzfrequenz auszeichnet. Dadurch wird die Steigung in der Übertragungsfunktion des Hochpass 15, der nun aus Bandsperre 14 und Kapazität 4 beziehungsweise Bandpass 13 gebildet wird, weiter erhöht. Durch die Tiefpassschaltung 8 auf der Sekundärseite des Übertragers 6 lässt sich auch diese erhöhte Steigung unterhalb der Resonanzfrequenz der Bandsperre 14 kompensieren. An der Spannungsmessung 7 kann somit ein Bandpassverhalten im Frequenzbereich der Resonanzfrequenz der Bandsperre im DC-Pfades 2 erzielt werden, wobei eine Gesamt-Übertragungsfunktion der Vorrichtung mit Hilfe der geeignet eingerichteten Tiefpassschaltung 8 insbesondere unterhalb der Resonanzfrequenz der Bandsperre 14 einen weitgehend konstanten Verlauf aufweisen kann. In einer bevorzugten Ausführungsform wird zudem die Resonanzfrequenz des Bandpass 13 im AC-Pfad 3, der durch die Reihenschaltung aus der Kapazität 4 und der primärseitigen Wicklung 5' des Übertragers 6 bei geeigneter Dimensionierung des Terminierungswiderstandes 10 gebildet wird, identisch zur Resonanzfrequenz der Bandsperre im DC-Pfad ausgelegt.

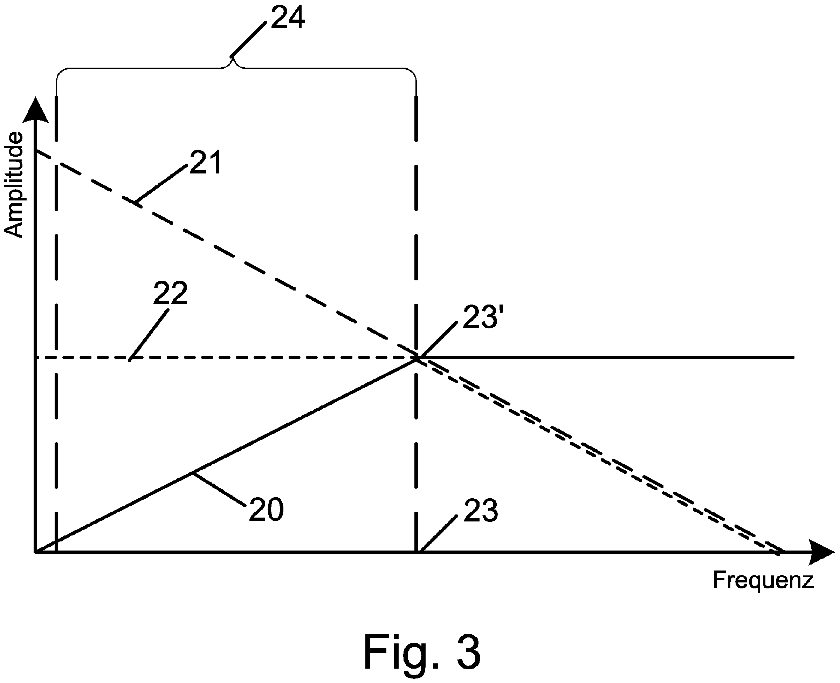

Fig. 3 zeigt beispielhaft für eine Vorrichtung gemäß Fig. 1 die Übertragungsfunktion 20 des Hochpass 15 aus Kapazität 4 und Induktivität 9, die Übertragungsfunktion 21 der Tiefpassschaltung 8 sowie die resultierende Gesamt-Übertragungsfunktion 22 der Vorrichtung. Die Übertragungsfunktion 20 des Hochpass 15 aus Kapazität 4 und Induktivität 9 weist eine Grenzfrequenz 23 auf, die mit einem Übergang von einem linearen Anstieg in einen konstanten Verlauf der Übertragungsfunktion 20 am Grenzpunkt 23' zusammenfällt, wobei aufgrund der geeigneten Wahl des Terminierungswiderstandes 10 die bei Verwendung eines Übertragers 6 ohne Terminierungswiderstandes auftretende Resonanzüberhöhung bei der Grenzfrequenz 23 derart gedämpft ist, dass eine monoton steigende Übertragungsfunktion 20 entsteht. In dieser Ausführungsform wurde die Grenzfrequenz 23 für das obere Ende des Frequenzbereichs 24 der zu detektierenden AC-Anteile gewählt. Der Frequenzbereich 24 der zu detektierenden AC-Anteile liegt somit im tieffrequenten Sperrbereich der Übertragungsfunktion 20, in dem eine Dämpfung der AC-Anteile durch den Hochpass 15 aus Kapazität 4 und Induktivität 9 stattfindet.

Die dem Übertrager sekundärseitig nachgeschaltete Tiefpassschaltung 8 besitzt eine Übertragungsfunktion 21, die insbesondere bei Frequenzen unterhalb der Grenzfrequenz 23 genau gegenläufig, d.h. komplementär zur Übertragungsfunktion 20 des Hochpass 15 aus Kapazität 4 und Induktivität 9 ist, indem sie einen Verlauf mit identischer Steigung, aber umgekehrtem Vorzeichen der Steigung aufweist. Dadurch ergibt sich eine Gesamt-Übertragungsfunktion 22, die im Frequenzbereich 24 der zu detektierenden AC-Anteile i_{AC}(t) einen messtechnisch idealen konstanten Verlauf aufweist, so dass die am Ausgang der Tiefpassschaltung 8 angeordnete Spannungsmesseinrichtung 7 ein Ausgangssignal bereitstellt, dass den zu detektierenden AC-Anteilen entspricht, indem es proportional und linear zu ihnen ist. In der Realität weist die Gesamt-Übertragungsfunktion 22 im Gegensatz zur nicht durch die Tiefpassschaltung 8 kompensierten Übertragungsfunktion 20 insbesondere keine monotone Steigung mehr auf und ihre Variation beträgt nur noch wenige dB/Dekade , ist also mithin um mindestens den Faktor 5 kleiner als die Variation der Übertragungsfunktion 20.

Konkret beträgt die Steigung der Übertragungsfunktion 20 des in Fig. 2 dargestellten Hochpass 15 aus Bandsperre 14 und Bandpass 13 im Frequenzbereich 24 der zu messenden AC-Anteile +40 dB/Dekade. Um eine Linearisierung der Gesamt-Übertragungsfunktion 22 zu erzielen, muss die Tiefpassschaltung 8 eine entsprechend gegenläufige Übertragungsfunktion 21 mit einer Steigung von -40 dB/Dekade besitzen. Dies kann beispielsweise durch einen passiven Tiefpass zweiter Ordnung erreicht werden.

Um neben der Nichtlinearität der Übertragungsfunktion 20 des Hochpass 15 im Frequenzbereich 24 der zu messenden AC-Anteile i_{AC}(t) zusätzlich die Dämpfung dieser AC-Anteile i_{AC}(t) auszugleichen, kann die Tiefpassschaltung 8 als aktive Tiefpassschaltung, insbesondere als Integrator zweiter Ordnung aus einer Reihenschaltung zweier aktiver invertierender oder nicht-invertierender Integratorschaltungen mit Operationsverstärkern mit je 20 dB/Dekade Verstärkung ausgebildet sein.

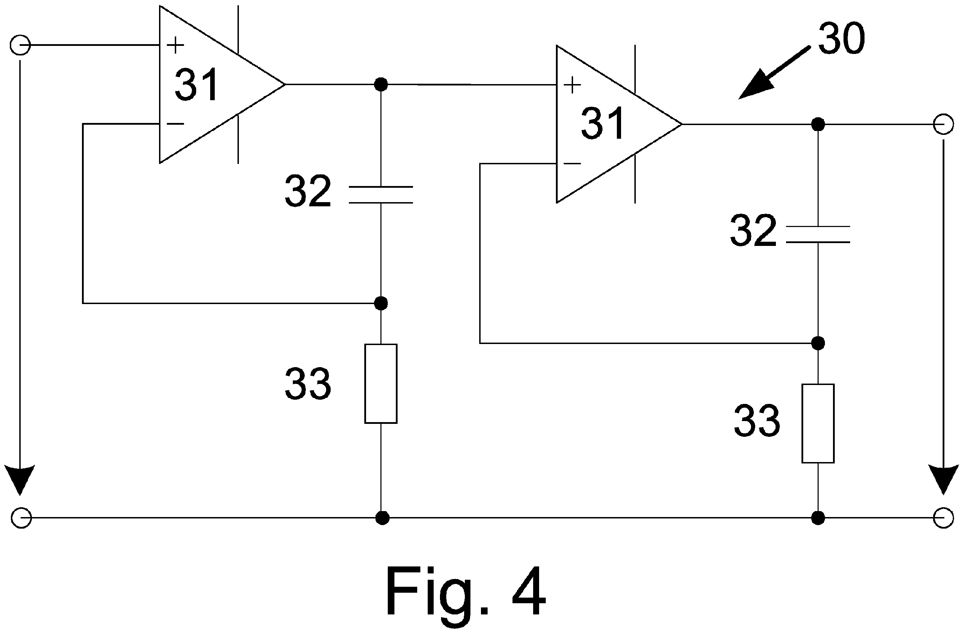

Fig. 4 zeigt beispielhaft eine Tiefpassschaltung 8 in Form einer aktiven, nichtinvertierenden Integratorschaltung 30 zweiter Ordnung mit zwei Operationsverstärkern 31. Diese Integratorschaltung 30 besitzt aufgrund der den Operationsverstärkern zugeordneten Kondensatoren 32 eine frequenzabhängige Verstärkung und stellt einen aktiven Tiefpass dar, dessen Eigenschaften zusätzlich anhand der Widerstände 33 optimiert werden können.

Wird eine solche aktiven, nichtinvertierenden Integratorschaltung 30 eingesetzt, kann die Gesamt-Übertragungsfunktion 22 auch für Frequenzen oberhalb der Grenzfrequenz 23 linearisiert werden, indem eine Integrationszeitkonstante der nichtinvertierenden Integratorschaltung 30 derart auf die Übertragungsfunktion 20 des Hochpass 15 abgestimmt wird, dass die Verstärkung der nichtinvertierenden Integratorschaltung 30 oberhalb der Grenzfrequenz 23 des Hochpass 15 den Wert 1 annimmt. Damit ergibt sich am Ausgang des Tiefpasses 8 auch über die Grenzfrequenz 23 hinaus ein konstanter Verlauf der Gesamt-Übertragungsfunktion 22, und der Frequenzbereich 24 der zu messenden AC-Anteile i_{AC}(t) kann zu Frequenzen oberhalb der Grenzfrequenz erstreckt werden. Je nach Konfiguration der Bauelemente des Hochpass 15, insbesondere der Dimensionierung des Terminierungswiderstandes 10 und ob der DC-Pfad die Induktivität 9 oder die Bandsperre 14 umfasst, kann zudem der Verlauf der Gesamt-Übertragungsfunktion 22 im Bereich der Grenzfrequenz 23 einen monotonen Verlauf oder eine Resonanzüberhöhung aufweisen.

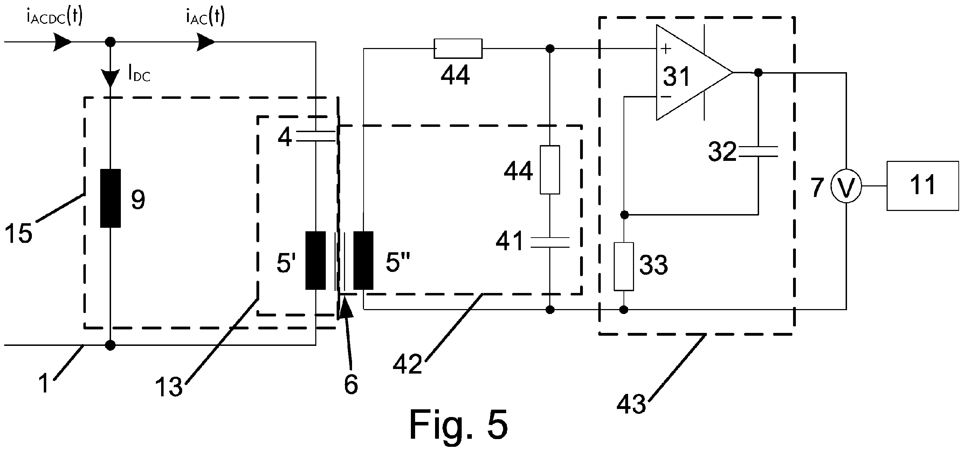

In Fig. 5 ist eine alternative Ausführungsform der Vorrichtung dargestellt, in der im DC-Pfad 2 des Gleichstromkreises 1 eine Induktivität 9 und parallel zur sekundärseitigen Wicklung 5" des Übertragers 6 eine Kapazität 41 angeordnet ist, die zusammen mit der Streuinduktivität der sekundärseitigen Wicklung 5" des Übertragers 6 einen Resonanzkreis 42 ausbildet. Die Bauteile dieses Resonanzkreises 42 können so dimensioniert werden, dass der Resonanzkreis 42 eine Resonanzstelle unterhalb der Grenzfrequenz 23 und innerhalb des Frequenzbereiches 24 ausprägen. Bevorzugt entspricht die Resonanzfrequenz des Resonanzkreises 42 dabei der unteren Grenze des vorgegebenen Frequenzbereiches 24. Durch diesen Resonanzkreis 42 wird die Steigung der Übertragungsfunktion 20 des Hochpass 15 im Frequenzbereich 24 der zu messenden AC-Anteile auf 20 dB/Dekade reduziert. Diese derart reduzierte Steigung kann durch einen Tiefpass 8 erster Ordnung, beispielsweise durch die in Fig. 5 dargestellte Integratorschaltung 43 erster Ordnung aus Operationsverstärker 31 und Kondensator 32 mit einer Verstärkung von 20 dB/Dekade im Frequenzbereich 24 der zu messenden AC-Anteile kompensiert werden. Anhand der optionalen Widerstände 44 kann die Dämpfung im Bereich der Resonanzfrequenz 23 des Resonanzkreises 42 weiter optimiert werden, um mittels der Kombination aus Induktivität 9, Bandpass 13, Resonanzkreis 42 und Integratorschaltung 43 eine lineare Gesamt-Übertragungsfunktion 22 der Vorrichtung in einem erweiterten Frequenzbereich zu erzielen. Konkret kann beispielweise der Verlauf der Gesamt-Übertragungsfunktion 22 im Bereich der Grenzfrequenz 23 durch geeignete Wahl der Bauteile und/oder durch Hinzufügen eines Widerstandes in Reihe mit der primärseitigen Wicklung 5' des Übertragers 6 auf den konkreten Anwendungsfall optimiert und beispielsweise in linearisiert werden, so dass der Frequenzbereich der zu detektierenden AC-Anteile i_{AC}(t) über die Grenzfrequenz 23 hinaus erstreckt werden kann.

### Bezugszeichenliste

- 1: Gleichstromkreis
- 2: DC-Pfad
- 3: AC-Pfad
- 4: Kapazität
- 5': Primärseitige Wicklung
- 5": Sekundärseitige Wicklung
- 6: Übertrager
- 7: Spannungsmesseinrichtung
- 8: Tiefpassschaltung
- 9: Induktivität
- 10: Terminierungswiderstand
- 11: Auswerteeinrichtung
- 12: Kapazität
- 13: Bandpass
- 14: Bandsperre
- 15: Hochpass
- 20: Übertragungsfunktion
- 21: Übertragungsfunktion
- 22: Gesamt-Übertragungsfunktion
- 23: Grenzfrequenz
- 23': Grenzpunkt
- 24: Frequenzbereich
- 30: Integratorschaltung
- 31: Operationsverstärker
- 32: Kondensator
- 33: Widerstand
- 41: Kapazität
- 42: Resonanzkreis
- 43: Integratorschaltung
- 44: Widerstand

## Patentansprüche

1. Vorrichtung zur Erfassung von Wechselstromanteilen i_{AC} eines in einem Gleichstromkreis (1) fließenden elektrischen Stromes i_{ACDC}, umfassend:
- eine in dem Gleichstromkreis (1) angeordnete Induktivität (9),
- einen elektrisch parallel zu der Induktivität (9) angeordneten AC-Pfad (3), wobei der AC-Pfad (3) eine Reihenschaltung aus einer Kapazität (4) und einer primärseitigen Wicklung (5') eines Übertragers (6) umfasst, so dass die Wechselstromanteile i_{AC} des Stromes bevorzugt über den AC-Pfad (3) geleitet werden,
- eine Spannungsmesseinrichtung (7),
**dadurch gekennzeichnet, dass**
eine sekundärseitige Wicklung (5") des Übertragers (6) über eine Tiefpassschaltung (8) mit der Spannungsmesseinrichtung (7) verbunden ist, wobei die Tiefpassschaltung (8) zur Linearisierung der Wechselstromanteile i_{AC} eingerichtet ist, so dass in einem vorgegebenen Frequenzbereich (24) eine lineare Abbildung der Wechselstromanteile i_{AC} im Gleichstromkreis (1) auf mittels der Spannungsmesseinrichtung (7) gemessene Wechselspannungen erzielt wird.

2. Vorrichtung nach Anspruch 1, **dadurch gekennzeichnet, dass** elektrisch parallel zu der Induktivität (9) eine Kapazität (12) angeordnet ist, so dass die Parallelschaltung aus der Induktivität (9) und der Kapazität (12) eine Bandsperre (14) bildet.

3. Vorrichtung nach Anspruch 1 oder 2, **dadurch gekennzeichnet, dass** der Übertrager (6) einen Terminierungswiderstand aufweist, der bevorzugt elektrisch parallel zu der sekundärseitigen Windung (5") angeordnet ist.

4. Vorrichtung nach einem der Ansprüche 1 bis 3, **dadurch gekennzeichnet, dass** die Tiefpassschaltung (8) derart ausgelegt ist, dass eine Übertragungsfunktion (21) der Tiefpassschaltung (8) in dem vorgegebenen Frequenzbereich (24) einen Verlauf aufweist, der in dem vorgegebenen Frequenzbereich (24) komplementär zum Verlauf einer Übertragungsfunktion (20) eines die Induktivität (9) und die Kapazität (4) umfassenden Hochpass (15) ist, so dass der Verlauf einer Gesamt-Übertragungsfunktion (22) der Vorrichtung in dem vorgegebenen Frequenzbereich (24) eine mindestens um den Faktor 5 gegenüber der Übertragungsfunktion (20) des Hochpass (15) reduzierte Variation aufweist.

5. Vorrichtung nach Anspruch 4, **dadurch gekennzeichnet, dass** eine Grenzfrequenz (23) des Hochpass (15) aus Induktivität (9) beziehungsweise Bandsperre (14) und Kapazität (4) oberhalb des vorgegebenen Frequenzbereiches (24) liegt, wobei mindestens ein Faktor 5 zwischen der Grenzfrequenz (23) und einer unteren Grenze des vorgegebenen Frequenzbereiches (24) liegt.

6. Vorrichtung nach einem der Ansprüche 1 bis 5, **dadurch gekennzeichnet, dass** die Tiefpassschaltung (8) ein aktiver Tiefpass ist.

7. Vorrichtung nach Anspruch 6, **dadurch gekennzeichnet, dass** die Tiefpassschaltung (8) eine Integratorschaltung (30, 43) ist und einen Operationsverstärker (31) umfasst.

8. Vorrichtung nach einem der Ansprüche 5 bis 7, **dadurch gekennzeichnet, dass** parallel zur sekundärseitigen Wicklung (5") des Übertragers (6) eine Kapazität (41) angeordnet ist, die zusammen mit einer Streuinduktivität der sekundärseitigen Wicklung (5") des Übertragers (6) einen Resonanzkreis (42) ausbildet, wobei eine Resonanzfrequenz des Resonanzkreises (42) zwischen der Grenzfrequenz (23) des Hochpass (15) und der unteren Grenze des vorgegebenen Frequenzbereiches (24) liegt.

9. Vorrichtung nach Anspruch 6, **dadurch gekennzeichnet, dass** die Tiefpassschaltung (8) eine Integratorschaltung (30) zweiter Ordnung ist und eine Reihenschaltung von Operationsverstärkern (31) umfasst.

10. Vorrichtung nach einem der vorangehenden Ansprüche, **dadurch gekennzeichnet, dass** die Vorrichtung eine Auswerteeinrichtung (11) aufweist, die dazu eingerichtet ist, die mittels der Spannungsmesseinrichtung (7) erfassten Wechselstromanteile i_{AC} zur Detektion von Lichtbögen im Gleichstromkreis (1) und/oder zum Empfang von Powerline-Kommunikationssignalen auszuwerten.

11. Vorrichtung nach einem der vorangehenden Ansprüche, **dadurch gekennzeichnet, dass** die Auswerteeinrichtung (11) dazu eingerichtet ist, die mittels der Spannungsmesseinrichtung (7) erfassten Wechselstromanteile i_{AC} in einem ersten vorgegebenen Frequenzbereich (24) zur Detektion von Lichtbögen im Gleichstromkreis (1) und in einem zweiten vom ersten Frequenzbereich (24) unterschiedlichen Frequenzbereich zum Empfang von Powerline-Kommunikationssignalen auszuwerten.

12. Vorrichtung nach Anspruch 11, **dadurch gekennzeichnet, dass** eine mittlere Frequenz der Powerline-Kommunikationssignale oberhalb des ersten vorgegebenen Frequenzbereiches (24) liegt, wobei die mittlere Frequenz der Powerline-Kommunikationssignale bevorzugt einer Resonanzfrequenz des Bandpass (13) und/oder der Bandsperre (14) entspricht.

13. Verwendung der Vorrichtung nach einem der vorangehenden Ansprüche in einem Gleichstromkreis einer Photovoltaikanlage.

## Claims

1. A device for detecting alternating-current components i_{AC} of an electric current i_{ACDC} flowing in a direct-current circuit (1), comprising:
- an inductor (9) arranged in the direct-current circuit (1),
- an AC path (3) arranged electrically in parallel with the inductor (9), wherein the AC path (3) comprises a series circuit made up of a capacitor (4) and a primary side winding (5') of a transformer (6),
- a voltage measuring device (7),
**characterized in that**
a secondary side winding (5") of the transformer (6) is connected to the voltage measuring device (7) via a low-pass filter circuit (8), wherein the low-pass filter circuit (8) is configured for linearization of the alternating-current components i_{AC}, such that a linear transformation of the alternating-current components i_{AC} within the direct-current circuit (1) into alternating-currents measured by the voltage measuring device (7) is obtained in a predefined frequency range.

2. The device as claimed in claim 1, **characterized in that** a capacitor (12) is arranged electrically in parallel with the inductor (9), so that the parallel circuit made up of the inductor (9) and the capacitor (12) forms a band-stop filter (14).

3. The device as claimed in claim 1 or 2, **characterized in that** the transformer (6) comprises a termination resistor which is preferably arranged electrically in parallel with the secondary side winding (5").

4. The device as claimed in one of claims 1 to 3, **characterized in that** the low-pass filter circuit (8) is designed in such a way that a transfer function (21) of the low-pass filter circuit (8) in the predefined frequency range (24) has a profile which is complementary to the profile of a transfer function (20) of a high-pass filter (15) comprising the inductor (9) and the capacitor (4) in the predefined frequency range (24), so that the profile of an overall transfer function (22) of the device in the predefined frequency range (24) has a variation which is reduced at least by a factor of 5 with respect to the transfer function (20) of the high-pass filter (15).

5. The device as claimed in claim 4, **characterized in that** a cutoff frequency (23) of the high-pass filter (15) made up of an inductor (9) or a band-stop filter (14) and a capacitor (4), respectively, lies above the predefined frequency range (24), wherein at least a factor of 5 lies between the cutoff frequency (23) and a lower limit of the predefined frequency range (24).

6. The device as claimed in one of claims 1 to 5, **characterized in that** the low-pass filter circuit (8) is an active low-pass filter.

7. The device as claimed in claim 6, **characterized in that** the low-pass filter circuit (8) is an integrator circuit (30, 43) and comprises an operational amplifier (31).

8. The device as claimed in one of claims 5 to 7, **characterized in that** a capacitor (41) is arranged in parallel with the secondary side winding (5") of the transformer (6), which, together with a leakage inductance of the secondary side winding (5") of the transformer (6), forms a resonant circuit (42), wherein a resonance frequency of the resonant circuit (42) lies between the cutoff frequency (23) of the high-pass filter (15) and the lower limit of the predefined frequency range (24).

9. The device as claimed in claim 6, **characterized in that** the low-pass filter circuit (8) is a second-order integrator circuit (30) and comprises a series connection of operational amplifiers (31).

10. The device as claimed in one of the preceding claims, **characterized in that** the device comprises an evaluation device (11) which is configured to evaluate the alternating-current components i_{AC} which are detected with the aid of the voltage measuring device (7) for the detection of arcs in the direct-current circuit (1) and/or for the reception of powerline communication signals.

11. The device as claimed in one of the preceding claims, **characterized in that** the evaluation device (11) is configured to evaluate the alternating-current components i_{AC} which are detected with the aid of the voltage measuring device (7), in a first predefined frequency range (24) for the detection of arcs in the direct-current circuit (1), and in a second frequency range, which is different from the first frequency range (24), for the reception of powerline communication signals.

12. The device as claimed in claim 11, **characterized in that** a center frequency of the powerline communication signals is above the first predefined frequency range (24), wherein the center frequency of the powerline communication signals preferably corresponds to a resonance frequency of the bandpass filter (13) and/or the band-stop filter (14).

13. The use of the device as claimed in one of the preceding claims in a direct-current circuit of a photovoltaic system.

## Revendications

1. Dispositif pour détecter des parties AC i_{AC} d'un courant électrique i_{ACDC} circulant dans un circuit DC (1), comprenant :
- une inductance (9) disposée dans ledit circuit continu (1),
- un trajet CA (3) disposé électriquement parallèlement à l'inductance (9), le trajet CA (3) comprenant un circuit série comprenant un condensateur (4) et un enroulement côté primaire (5') d'un transformateur (6), de sorte que les composants de courant alternatif i_{AC} du courant sont de préférence conduits via le trajet CA (3),
- un dispositif de mesure de tension (7),
**caractérisé en ce que**
un enroulement secondaire (5"') du transformateur (6) est relié au dispositif de mesure de tension (7) par l'intermédiaire d'un circuit passe-bas (8), le circuit passe-bas (8) étant configuré pour linéariser les composants CA i_{AC}, de sorte que la correspondance linéaire des composants CA i_{AC} du circuit CC (1) aux tensions CA mesurées par le dispositif de mesure de tension (7) est réalisée dans une plage de fréquence prédéterminée (24).

2. Dispositif selon la revendication 1, **caractérisé en ce qu'**une capacité (12) est disposée électriquement parallèlement à l'inductance (9), de sorte que la connexion parallèle de l'inductance (9) et de la capacité (12) forme une butée de bande (14).

3. Dispositif selon la revendication 1 ou 2, **caractérisé en ce que** le transformateur (6) présente une résistance de terminaison qui est de préférence disposée électriquement parallèlement à l'enroulement secondaire (5").

4. Dispositif selon l'une des revendications 1 à 3, **caractérisé en ce que** le circuit passe-bas (8) est conçu de telle sorte qu'une fonction de transfert (21) du circuit passe-bas (8) présente une caractéristique dans la plage de fréquences prédéterminée (24), qui, dans la plage de fréquences prédéterminée (24), est complémentaire du déroulement d'une fonction de transfert (20) d'un filtre passe-haut (15) comprenant l'inductance (9) et la capacité (4), de sorte que le déroulement d'une fonction de transfert globale (22) du dispositif dans la plage de fréquences prédéterminée (24) présente une variation qui est réduite par au moins un facteur 5 en relation avec la fonction de transfert (20) du filtre passe-bas (15).

5. Dispositif selon la revendication 4, **caractérisé en ce qu'**une fréquence de coupure (23) du filtre passe-haut (15) constituée d'inductance (9) ou d'arrêt de bande (14) et de capacité (4) est supérieure à la plage de fréquences prédéterminée (24), au moins un facteur 5 étant compris entre la fréquence de coupure (23) et une limite inférieure de la plage de fréquences prédéterminée (24).

6. Dispositif selon l'une des revendications 1 à 5, **caractérisé en ce que** le circuit passe-bas (8) est un filtre passe-bas actif.

7. Dispositif selon la revendication 6, **caractérisé en ce que** le circuit passe-bas (8) est un circuit intégrateur (30, 43) et comprend un amplificateur opérationnel (31).

8. Dispositif selon l'une des revendications 5 à 7, **caractérisé en ce qu'**un condensateur (41) est disposé parallèlement à l'enroulement secondaire (5") du transformateur (6), lequel condensateur forme avec une inductance de fuite de l'enroulement secondaire (5") du transformateur (6) un circuit résonant (42), une fréquence résonante du circuit résonant (42) située entre la fréquence de coupure (23) du filtre passe-haut (15) et la limite inférieure de la plage prédéterminée (24).

9. Dispositif selon la revendication 6, **caractérisé en ce que** le circuit passe-bas (8) est un circuit intégrateur du second ordre (30) et comprend un circuit série d'amplificateurs opérationnels (31).

10. Dispositif selon l'une des revendications précédentes, **caractérisé en ce que** le dispositif comporte un dispositif d'évaluation (11) qui est conçu pour évaluer les composantes de courant alternatif i_{AC} détectées au moyen du dispositif de mesure de tension (7) pour la détection d'arcs dans le circuit DC (1) et/ou pour la réception de signaux de communication sur la ligne électrique.

11. Dispositif selon l'une des revendications précédentes, **caractérisé en ce que** le dispositif d'évaluation (11) est conçu pour évaluer les composantes de courant alternatif i_{AC} détectées au moyen du dispositif de mesure de tension (7) dans une première plage de fréquences prédéterminée (24) pour la détection d'arcs dans le circuit CC (1) et dans une seconde plage de fréquences différente de la première plage de fréquences (24) pour la réception de signaux de communication sur ligne électrique.

12. Dispositif selon la revendication 11, **caractérisé en ce qu'**une fréquence moyenne des signaux de communication powerline est supérieure à la première plage de fréquences prédéterminée (24), la fréquence moyenne des signaux de communication powerline correspondant de préférence à une fréquence de résonance du passe-bande (13) et/ou du coupe-bande (14).

13. Utilisation de l'appareil selon l'une des revendications précédentes dans un circuit CC d'une installation photovoltaïque.
